# EUROPEAN PATENT SPECIFICATION

(11) **EP 0 818 811 B1**
(45) Date of publication and mention of the grant of the patent: **15.12.1999**
(21) Application number: 96110873.5
(22) Date of filing: 05.07.1996
(51) Int. Cl.: H01L 21/48, H01L 21/60

(54) **Method of making solder bumps**
Herstellungsverfahren für Höcker
Procédé pour la fabrication de plots de contact

(43) Date of publication of application: 14.01.1998
(73) Proprietor: Hewlett-Packard Company, Palo Alto, California 94304 (US)
(72) Inventor: Kaminski, Janusz, 75365 Calw (DE)
(74) Representative: Harbach, Thomas

(56) References cited:
- EP-A- 0 327 398
- EP-A- 0 697 727
- DE-A- 4 326 424
- DE-A- 4 438 098
- IBM TECHNICAL DISCLOSURE BULLETIN, vol. 29, no. 9, February 1987, NEW YORK, pages 3817-3818, XP002020290 "placing solder terminals on silicon wafers"
- PATENT ABSTRACTS OF JAPAN vol. 18, no. 599 (E-1631) 15 November 1994 & JP-A-06 232 134 (ROHM CO LTD) 19 August 1994
- PATENT ABSTRACTS OF JAPAN vol. 018, no. 673 (E-1647) 19 December 1994 & JP-A-06 267 964 (ROHM CO LTD) 22 September 1994

## Description

The present invention concerns a method for fabricating a plurality of solder structures to a plurality of conductive pads for a surface mount device (SMD) on a surface of a printed circuit board (PCB).

The use of solder bumps on a substrate for attachment to a second substrate by a reflow process is well known in the art. Solder bumps are particularly useful with pad grid array substrates. The closeness or density of solder pads is limited using known technologies due to problems in providing high density solder bumps and preventing the solder bumps from flowing together and shorting pads and bumps when reflowed. US-A-5 024 372 discloses a method for forming solder bumps which includes the steps of applying a thick layer of a solder resist to a substrate. The solder resist is selectively removed to provide wells at solder pads on the substrate. The solder is then applied to form solder bumps on the pads. After forming the solder bumps, the remaining resist is removed. This process comprises after precleaning of the copper surface of the PCB the following detailed steps: A: applying of resist, B: exposure of the resist, C: development of the resist, D: applying of solder past, E: reflow, F: removing (stripping) of the resist, G: removing of the oxide layer. This process is time-consuming and understressing for the material of the PCB. Especially the stripping step F. provides increased oxidation of the solder and the surrounding copper. This requires additional process steps, which do not comply with the actual process aim. Further, requires the use of the resist, which is applied three times in order to obtain the desired height of the bumps, the additional above mentioned steps B., C., F. and G. During each step the product is unavoidable subject to liquids which, in a limited degree, influence the surface. Further, the chemical products have to be carefully handled because of their aggressiveness and should be avoided under environmental aspects.

EP-A-0 327 398 discloses an article and measured for making same by laser-ablation-machining of polyimeric materials. This special polyimeric material can be used for making uniaxially electrical conductive articles. The polyimeric material may comprise a laminar sheet having at least one layer of polyamide material and at least one layer of polyamide material. With a polyamide surface contamination can be avoided. The laser-radiation may be of any wavelengths curable of producing the desired ablation machining effect, for example an excimer laser.

The problem of the present invention is therefore to propose a method, which provides a reduced treatment of the PCB during the forming process of solder bumps.

According to the invention, this problem is solved by a process having the features of the mainclaim. Further advantageous developments can be gathered from the subclaims.

The method comprises the steps:
a) precleaning the surface of said printed circuit board having said conductive pads thereon;
b) adhering a polyimide foil to said surface with an adhesive based on synthetic elastomers and resins;
c) selectively removing portions of said polyimide foil and said adhesive over said pads with a laser to form wells which extend to said pads;
d) applying a solder paste only in said wells to contact said pads;
e) reflowing said solder paste to form said solder bumps on said pads; and then
f) removing said polyimide foil together with said adhesive which remains attached to said polyimide foil without leaving a residue on the printed circuit board.

This method of forming solder bumps includes after precleaning of the surface of the PCB the step of adhesion of a foil maid of a polymer. The foil is selectively removed over solder pads on the PCB by use of a laser. The removal can be performed by well-known laser, for example YAG-laser or excimer laser. Solder paste is then applied only in the wells formed in the previous step to contact the pads. Subsequent, as usual, the solder paste is reflowed to form solder bumps. Next the foil is removed together with the adhesive. During the removal of the foil the adhesive remains at the underside of the foil without residue on the surface of the PCB, so that, for example, an additional cleaning step for removing remaining adhesive from the surface is not necessary. Foil and adhesive are workable with a laser, but during the reflow step completely stabile. The new process now comprises after the precleaning step a smaller number of steps. This leads to a reduced understressing of the material as well as a reduced environmental load because, except of the precleaning step, all wet chemical steps are omitted. Further, this additionally reduces bottlenecks in the manufacturing line.

The foil can be self-adhesive foil, with an adhesive based on synthetic elastomers and resins which remains after the removal from the PCB at the foil, made of polyimide.

According to a preferred embodiment of the invention an excimer laser is used to provide the wells. It has be found, that the foil made of polyimide together with an excimer laser provides the best results, especially in connection with an adhesive based on synthetic elastomers and resins. Such an adhesive is sold by 3M under the trademark SPRAYMOUNT and generally known from US-A-3 857 731. Surprisingly, this adhesive does not influence the ablation process of the excimer laser and leads to exact holes in the foil.

In the following the invention is described in further details thereafter in connection with a preferred embodiment and the accompanying drawings. It shows:
- Fig. 1: a cross-sectional view of the substrate in the region of the surface with a foil and adhesive, and
- Fig. 2: a cross-sectional view according to Fig. 1 with solder bumps and removed foil.

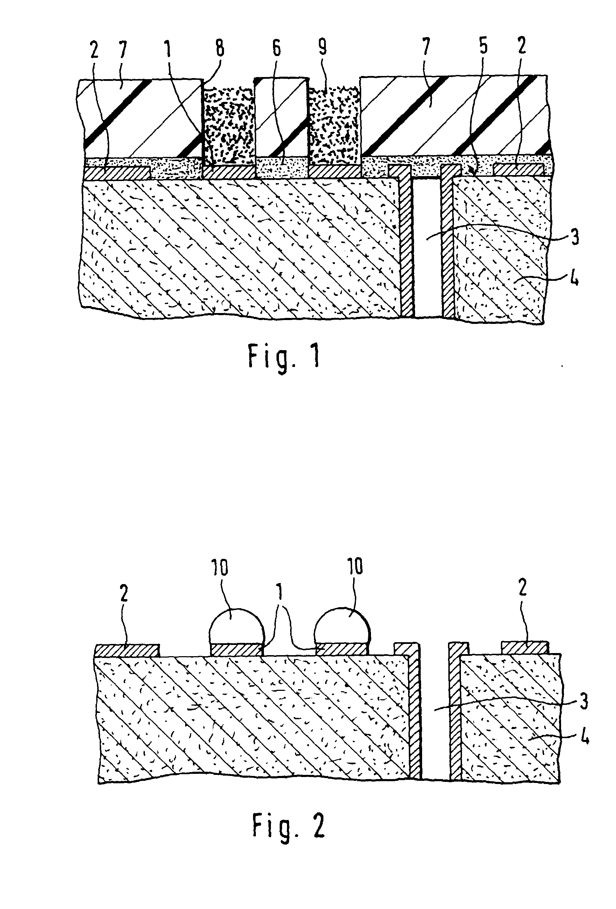

Fig. 1 shows a part of a printed circuit board with metalized pads 1, conductor patterns 2 and connection holes 3 on and in, respectively, the substrate 4. On the surface 5 of the substrate 4 a foil 7 with an adhesive 6 is applied. Solder bumps on selected pads 1 are formed by removal the foil 7 together with the adhesive 6 above the pads 1 with an excimer laser (not shown). After removal the holes 8 above the pads 1, the holes are filled with solder 9 and the desired well-known solder bumps 10 as shown in Fig. 2 are obtained by a subsequent reflow step .

According the method, after precleaning the surface of the PCB, a foil made of polyimide, for example a foil manufactured by DuPont and sold under the trademark KAPTON, is provided with an adhesive, for example an adhesive corresponding to the adhesive sold by 3M under the trademarks CREATIVEMOUNT or SPRAYMOUNT. This adhesive has the advantage that it allows the use of an excimer laser for providing the wells in view of the special ablation process. The maximum height of adhesive and foil is lower than the height of conventional resists in order to obtain bumps. This is initiated by the structure of the holes above the pads which are conical with a smaller diameter in the near of the pad. Such a structure effects an increase in heights of the bumps during reflow, so that the bumps are higher than the thickness of the foil.

## Claims

1. Method of fabricating a plurality of solder bumps (10) on a plurality of conductive pads (1) of a printed circuit board (2, 3, 4) for a surface mount device comprising the steps of:
a) precleaning the surface of said printed circuit board having said conductive pads (1) thereon;
b) adhering a polyimide foil (7) to said surface with an adhesive (6) based on synthetic elastomers and resins;
c) selectively removing portions of said polyimide foil and said adhesive over said pads with a laser to form wells (8) which extend to said pads;
d) applying a solder paste (9) only in said wells to contact said pads;
e) reflowing said solder paste to form said solder bumps on said pads; and then
f) removing said polyimide foil together with said adhesive which remains attached to said polyimide foil without leaving a residue on the printed circuit board.

2. Method according to claim 1, wherein said laser is an excimer laser.

3. Method according to claim 1 or 2, wherein the foil is a self-adhesive foil.

## Patentansprüche

1. Verfahren zur Herstellung einer Mehrzahl von Lötmittelhügeln (10) auf einer Mehrzahl von leitfähigen Kontaktstellen (1) einer Leiterplatte (2, 3, 4) für ein Oberflächenmontagebauelement, das die Schritte umfaßt:
a) Vorreinigen der Oberfläche der Leiterplatte mit den darauf befindlichen Kontaktstellen (1);
b) Ankleben einer Polyimidfolie (7) an der Oberfläche mit einem Klebemittel (6), das auf synthetischen Elastomeren und Harzen basiert;
c) selektives Entfernen von Bereichen der Polyimidfolie und des Klebemittels über den Kontaktstellen mit einem Laser, um Mulden (8) zu bilden, die sich bis zu den Kontaktstellen erstrecken;
d) Anbringen einer Lötmittelpaste (9) lediglich in den Mulden, um die Kontaktstellen zu kontaktieren;
e) Aufschmelzen der Lötmittelpaste, um die Lötmittelhügel auf den Kontaktstellen zu bilden; und dann
f) Entfernen der Polyimidfolie zusammen mit dem Klebemittel, das an der Polyimidfolie haften bleibt, ohne einen Rückstand auf der Leiterplatte zu hinterlassen.

2. Verfahren nach Anspruch 1, wobei der Laser ein Excimerlaser ist.

3. Verfahren nach Anspruch 1 oder 2, wobei die Folie eine Selbstklebefolie ist.

## Revendications

1. Procédé de fabrication d'une pluralité de bosses de soudure (10) sur une pluralité de plages de connexion conductrices (1) d'une carte à circuit imprimé (2, 3, 4), pour un dispositif pour montage en surface comportant les étapes consistant à :
a) pré-nettoyer la surface de ladite carte à circuit imprimé ayant lesdites plages de connexion conductrices (1) dessus,
b) coller une feuille de polyimide (7) sur ladite surface à l'aide d'un adhesif (6) à base d'élastomères et de résines synthétiques,
c) éliminer de manière sélective des parties de ladite feuille de polyimide et dudit adhésif sur lesdites plages de connexion à l'aide d'un laser pour former des puits (8) qui s'étendent dans lesdites plages de connexion,
d) appliquer une pâte de soudure (9) uniquement dans lesdits puits pour venir en contact avec lesdites plages de connexion,
e) refusionner ladite pâte de soudure pour former lesdites bosses de soudure sur lesdites plages de connexion, et alors
f) éliminer ladite feuille de polyimide ainsi que ledit adhésif qui reste fixé à ladite feuille de polyimide sans laisser un résidu sur la carte à circuit imprimé.

2. Procédé selon la revendication 1, dans lequel ledit laser est un laser à excimer.

3. Procédé selon la revendication 1 ou 2, dans lequel la feuille est une feuille autocollante.
